# EUROPEAN PATENT SPECIFICATION

(11) **EP 4 451 351 B1**
(45) Date of publication and mention of the grant of the patent: **09.12.2026**
(21) Application number: 22916201.1
(22) Date of filing: 03.01.2022
(51) Int. Cl.: G09F 9/33, G09F 27/00, H01G 9/20, H02S 40/38, G09F 19/22, H10F 55/00, H10F 77/90, H10H 29/20, H10H 29/49

(54) **TRANSPARENT DISPLAY DEVICE**
TRANSPARENTE ANZEIGEVORRICHTUNG
DISPOSITIF D'AFFICHAGE TRANSPARENT

(43) Date of publication of application: 23.10.2024
(73) Proprietor: LG Electronics Inc., Yeongdeungpo-gu Seoul 07336 (KR)
(72) Inventor: SHIM, Minhee, Seoul 06772 (KR)
(74) Representative: Frenkel, Matthias Alexander
(86) International application number: PCT/KR2022/000021
(87) International publication number: WO 2023/128039

(56) References cited:
- KR-A- 20050 058 692
- KR-A- 20080 102 673
- KR-A- 20100 130 478
- KR-A- 20170 125 746
- KR-A- 20190 086 040
- KR-A- 20200 026 769
- KR-U- 20190 000 497
- US-A1- 2006 174 938

## Description

### [Technical Field]

The present disclosure relates to a transparent display device capable of operating through self-power generation.

### [Background Art]

There are many different types of display modules that implement images. For example, there are various display modules such as a liquid crystal display panel (LCD), a light emitting diode display panel (LED), a plasma display panel (PDP), and an organic light emitting diode display panel (OLED).

Also, film-type display modules that implement images are known. In particular, with the spread of the OLED, a transparent and flexible film-type display panel, lighter and thinner display devices can be realized, and displays can be installed in various places with transparency controlled.

In particular, recently, display devices that output images using transparent and flexible display modules attached to glass such as windows have been used for outdoor advertisement.

In particular, ultra-small LEDs, such as micro-LEDs, are not visible to the naked eye due to their small size. Thus, a transparent display device can be realized by leaving the area around the micro-LEDs transparent while each micro-LED implements a pixel.

However, unlike mountable display devices, these installable display devices require wiring to supply power and must be installed on-site by installers. KR 2008 0102673 A discloses an LED light emitting device including a solar panel of a transparent or half-transparent type to reduce an accrued cost according to a power use by overcoming restriction of an installation position according to a connection of a power line for a power supply. In the document the LED light emitting device including a solar panel of a transparent or half-transparent type is described to comprise a base plate, a transparent plate which is separated to be faced with the base plate, a plurality of LED light emitting parts arranged in a first side which is in opposite direction to the transparent plate of the base plate, a circuit pattern part formed in the first side of the base plate, a solar panel producing the power source by converting a light into an electrical energy, and a controller controlling a flash of the LED light emitting part by the power source generated with the solar panel.

### [Disclosure]

### [Technical Problem]

An object of the present disclosure devised to solve the above-described problems is to provide a transparent display device capable of self-supplying power for outputting images by having a transparent solar panel on the front.

### [Technical Solution]

The invention is defined by the appended claims.

### [Advantageous Effects]

According to an embodiment of the present disclosure, a transparent display device may self-generate and self-supply power, thereby eliminating the need for wiring for power supply and providing the convenience of simple installation with fewer restrictions on the installation site.

Furthermore, the transparent base located on one side of the transparent display device may be shared with a solar panel. Therefore, the present disclosure may reduce manufacturing costs and reduce thickness.

Effects obtainable from the present disclosure are not limited by the above mentioned effects, and other unmentioned effects can be clearly understood from the above description by those having ordinary skill in the technical field to which the present disclosure pertains.

### [Description of Drawings]

FIG. 1 is a view illustrating an example installation of a transparent display device installed on a window according to one embodiment of the present disclosure.
FIG. 2 is a cross-sectional view illustrating a conventional transparent display device.
FIG. 3 is a cross-sectional view illustrating a transparent display device according to the present disclosure.

### [Best Mode]

Description will now be given in detail according to exemplary embodiments disclosed herein, with reference to the accompanying drawings. For the sake of brief description with reference to the drawings, the same or equivalent components may be provided with the same reference numbers, and description thereof will not be repeated.

In general, a suffix such as "module" and "unit" may be used to refer to elements or components. Use of such a suffix herein is merely intended to facilitate description of the specification, and the suffix itself is not intended to give any special meaning or function. In the present disclosure, that which is well-known to one of ordinary skill in the relevant art has generally been omitted for the sake of brevity. The accompanying drawings are used to help easily understand various technical features and it should be understood that the embodiments presented herein are not limited by the accompanying drawings. As such, the present disclosure should be construed to extend to any alterations, equivalents and substitutes in addition to those which are particularly set out in the accompanying drawings.

It will be understood that although the terms first, second, etc. may be used herein to describe various elements, these elements should not be limited by these terms. These terms are generally only used to distinguish one element from another.

It will be understood that when an element is referred to as being "connected with" another element, the element can be directly connected with the other element or intervening elements may also be present. In contrast, when an element is referred to as being "directly connected with" another element, there are no intervening elements present.

A singular representation may include a plural representation unless it represents a definitely different meaning from the context.

Terms such as "include" or "has" are used herein and should be understood that they are intended to indicate an existence of several components, functions or steps, disclosed in the specification, and it is also understood that greater or fewer components, functions, or steps may likewise be utilized.

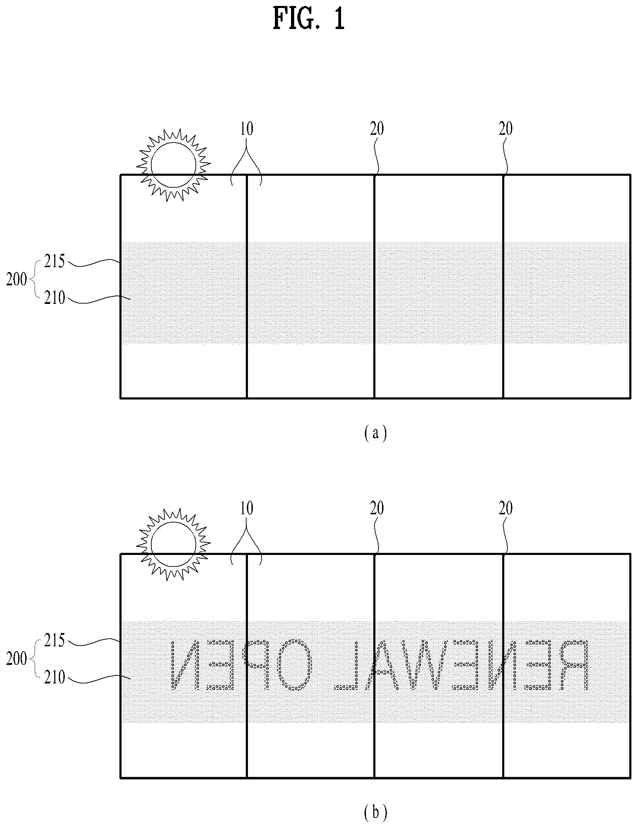

FIG. 1 is a view illustrating an example installation of a transparent display device 200 installed on a window 10 according to one embodiment of the present invention. This is a view taken from the inside of the window 10, wherein (a) shows the display device 200 in an off state, and (b) shows the display device 200 in an on state.

The transparent display device 200 of the present disclosure is installed on the window 10, and a display film 210 installed on the window 10 is transparent to allow one to see the outside from the inside or to see the inside from the outside.

As the transparent display film 210 increases in size, the number of signal wires increases. Therefore, the transparent display film 210 is modularized and manufactured in a predetermined size, and a plurality of transparent display films 210 may be arranged in a grid on the window 10 to form the transparent display device 200 with a large screen.

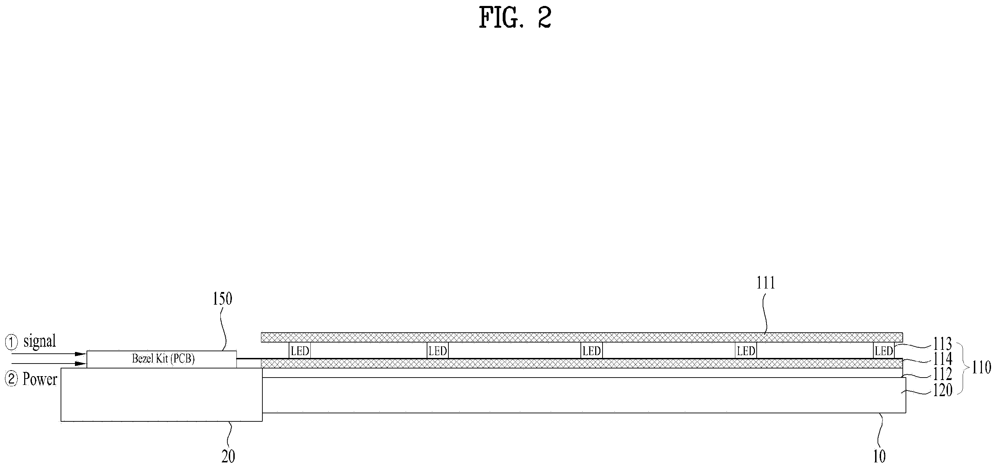

FIG. 2 is a view illustrating one example of a conventional transparent display device 100. The conventional transparent display device 100 may include a plurality of LEDs arranged at predetermined intervals as light sources 113 on a transparent base 111, and a display PCB 150 arranged at an end of the base 111 to control the light sources 113. By disposing the display PCB 150 on a bezel 20, the opaque display PCB may overlap the bezel 20 and be installed so as not to be noticed by the user.

The transparent display device may be attached to the transparent window 10 using an adhesive layer 120. The adhesive layer 120 may be formed of a transparent material, such as an optical clear adhesive (OCA), to allow light from the light sources 113 to pass therethrough.

The transparent display device 200 may be installed on the inside of the window 10 facing an indoor or outdoor area. Other non-transparent components (e.g., the display PCB, the communication part, the system controller and the power supply for controlling a plurality of display films 210) should be installed in a separate place.

Wiring is required from the system controller and power supply to the display films 210 attached to the window. In particular, the installation location is limited for external power supply, and the wiring is long in places without power.

To address the aforementioned issues, a self-powered transparent display device 200 is needed, and the present disclosure may employ a solar panel 230 overlapping the display film 210.

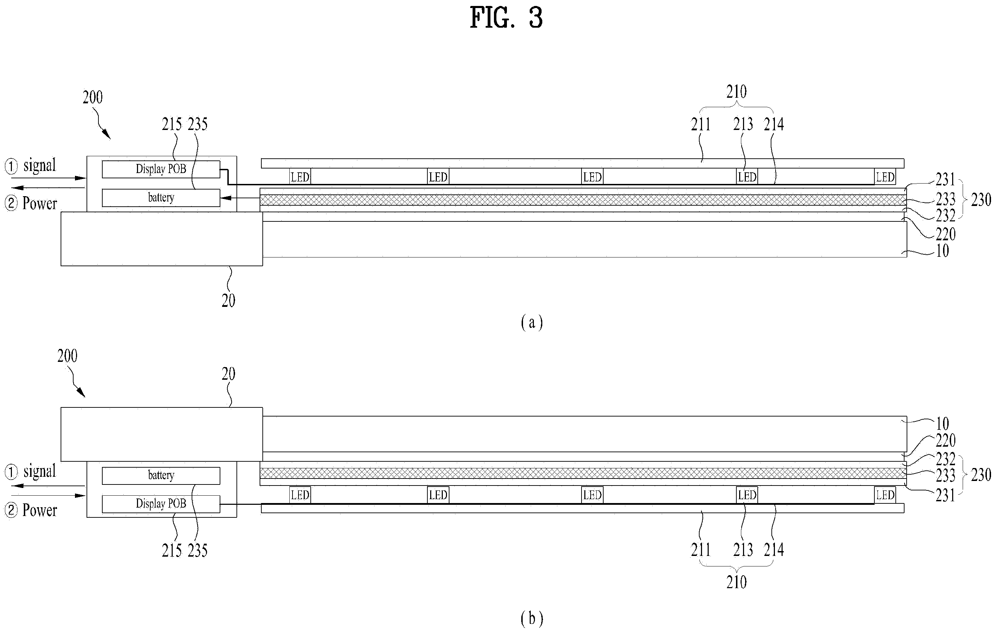

FIG. 3 is a cross-sectional view illustrating the transparent display device 200 of the present disclosure.

The display film 210 may have a plurality of LEDs disposed at predetermined intervals as light sources 213 on a transparent base 211, and a display PCB 215 provided at an end of the base 211 and disposed on a bezel. A transparent electrode 214 connecting the light sources 213 and the display PCB 215 may be formed on the base 111.

A surface of the transparent display device 200 on which images are output may be positioned facing the outside of the building such that the images can be viewed from the opposite side of the window 10.

Since the solar panel 230 requires sunlight to generate electricity, it should be located between the window 10 and the transparent display film 210, as shown in FIG. 3, to increase its efficiency.

Thus, the transparent solar panel 230 may be used to allow the images output from the display film 210 to be transmitted through the solar panel 230.

The solar panels 230 may be broadly divided into a silicon semiconductor type, a compound semiconductor type, and a dye-sensitized type.

The silicon semiconductor type is made by bonding p-type semiconductors and n-type semiconductors using a silicon wafer and placing electrodes on the front and back surfaces. When the silicon semiconductor type receives sunlight, pairs of electrons and holes are generated, and the electrons and holes flow in opposite directions under the influence of the electric field present at the p-n junction, and current flows by connecting the electrodes located on the front and back surfaces.

However, the silicon wafers used for the silicon type solar panels do not allow light to be transmitted therethrough. Instead, the silicon is densely drilled with fine holes on the order of tens of micrometers to implement a solar panel that allows light to be transmitted therethrough. Since objects on the other side can be recognized through the microscopic holes, the panel may be perceived as transparent.

The microscopic holes may increase the flexibility of the solar panel, enabling the implementation of a bendable solar panel. The transparent display film 210 is also bendable when molded on the film-like bendable transparent base 211, and thus may be installed on a curved window 10.

The compound semiconductor solar panel is similar in driving principle to the silicon semiconductor solar panel, but the material used is a compound rather than silicon. Examples of the compounds include copper indium selenium (CIS)-based, copper indium gallium selenium (CIGS)-based, and cadmium telluride (CdTe)-based materials.

The dye-sensitized type solar panel (dye-sensitized solar cell (DSSC)) generates electricity when the dye, like chlorophyll in plants, moves electrons in the presence of light. The dye-sensitized type solar panel is composed of a redox electrolyte, and the dye molecules chemically adsorbed on the surface of the panel may generate electricity by releasing electrons in the presence of sunlight.

The dye-sensitized type solar panels are less efficient than the silicon type solar panels, and therefore the commercialization rate of dye-sensitized type solar panels is still low.

However, the dye-sensitized type solar panels are easier to make than the silicon type solar panels, and may thus require lower manufacturing costs. Further, they have higher stability, and may thus be used for a longer period of time.

They may be implemented with transparency because a transparent base is available instead of opaque silicon. Furthermore, the DSSCs can generate electricity even on cloudy days when direct sunlight is weak, and may thus be used indoors to generate electricity.

As such, the transparent solar panel 230 may be implemented using a dye-sensitized type solar panel or a silicon-type solar panel having microscopic holes. However, the silicon-type solar panel having microscopic holes has a problem that the visibility of the image output from the transparent display decreases if the light sources 213 and the microscopic holes do not overlap when the solar panel is arranged to overlap the transparent display film 210. Thus, the following description will be based on the dye-sensitized type solar panel 230.

For the dye-sensitized type solar panel, a photoactive layer 233 may be implemented using nano-sized oxide (titanium oxide, TiO₂) particles with dye adsorbed on them and an electrolyte. The solar panel 230 may be manufactured by interposing the photoactive layer 233 between a pair of transparent bases 231 and 232 on which transparent electrodes are formed.

Since the solar panel 230 and the transparent display film 210 both require transparent bases 211, 231, and 232, the solar panel 230 may be implemented by omitting the transparent base abutting the transparent display film 210 and using the transparent base 231 of the display film 210.

The power generated by the solar panel 230 may be used to drive the transparent display film 210. A battery 235 that stores power generated by the solar panel 230 may be disposed with a system controller, and may be disposed on the bezel 20 along with the display PCB 215 as shown in FIG. 3.

The power generated by the solar panel 230 may not only drive the light sources 213 of the transparent display film 210, but may also power the system controller.

According to embodiments of the present disclosure, electricity may be produced and supplied independently, and therefore wiring for power supply may be omitted.

Therefore, the installation is simple and there are fewer restrictions on the installation site.

Furthermore, according to the present disclosure, the transparent base located on one side of the transparent display device 200 may be shared with the solar panel 230, thereby reducing manufacturing costs and reducing thickness.

The invention is defined by the appended claims.

## Claims

1. An assembly comprising a window (10) having a bezel (20), and a transparent display device installed on the window (10), the transparent display device comprising:
a first base (211) and a second base (231) each comprising a light-transmissive material;
a plurality of light sources (213) disposed between the first base (211) and the second base (231);
a display PCB (215) configured to control the light sources (213) and disposed at an end of the first base (211);
a transparent electrode (214) connecting the light sources and the display PCB (215);
a photoactive layer (233) formed on the second base (231) to convert sunlight into electrical energy;
a battery (235) configured to store the electrical energy generated by the photoactive layer and disposed at the end of the first base (211) along with the display PCB (215);
a third base (232) arranged to cover the photoactive layer; and
a transparent adhesive layer (220) laminated to the third base (232) and adhered to the window,
wherein the display PCB (215) is powered by the battery (235), and
wherein the battery (235) and the display PCB (215) are disposed on the bezel (20) of the window along with the display PCB (215).

2. The transparent display device of claim 1, further comprising:
a system controller configured to provide an image signal to the display PCB (215),
wherein the system controller is driven by power supplied from the battery (235).

3. The transparent display device of claim 1, wherein the light sources (213) are arranged in a grid.

4. The transparent display device of claim 1, wherein the photoactive layer (233) comprises:
dye molecules configured to generate electrons upon receiving solar energy;
nanoporous titanium oxide particles having absorbed the dye molecules; and an electrolyte.

## Patentansprüche

1. Anordnung, umfassend ein Fenster (10), das eine Einfassung (20) aufweist, und eine transparente Anzeigevorrichtung, die an dem Fenster (10) angebracht ist, wobei die transparente Anzeigevorrichtung umfasst:
eine erste Basis (211) und eine zweite Basis (231), die jeweils ein lichtdurchlässiges Material umfassen;
eine Mehrzahl von Lichtquellen (213), die zwischen der ersten Basis (211) und der zweiten Basis (231) angeordnet sind;
eine Anzeige-PCB (215), die dazu eingerichtet ist, die Lichtquellen (213) zu steuern, und die an einem Ende der ersten Basis (211) angeordnet ist;
eine transparente Elektrode (214), die die Lichtquellen und die Anzeige-PCB (215) verbindet;
eine fotoaktive Schicht (233), die auf der zweiten Basis (231) ausgebildet ist, um Sonnenlicht in elektrische Energie umzuwandeln;
eine Batterie (235), die dazu eingerichtet ist, die durch die fotoaktive Schicht erzeugte elektrische Energie zu speichern, und die zusammen mit der Anzeige-PCB (215) an dem Ende der ersten Basis (211) angeordnet ist;
eine dritte Basis (232), die derart angeordnet ist, dass sie die fotoaktive Schicht bedeckt; und
eine transparente Klebeschicht (220), die auf die dritte Basis (232) laminiert und mit dem Fenster verklebt ist,
wobei die Anzeige-PCB (215) durch die Batterie (235) mit Strom versorgt wird, und
wobei die Batterie (235) und die Anzeige-PCB (215) zusammen mit der Anzeige-PCB (215) auf der Einfassung (20) des Fensters angeordnet sind.

2. Transparente Anzeigevorrichtung nach Anspruch 1, ferner umfassend:
eine Systemsteuerung, die dazu eingerichtet ist, der Anzeige-PCB (215) ein Bildsignal bereitzustellen,
wobei die Systemsteuerung durch von der Batterie (235) zugeführte Energie betrieben wird.

3. Transparente Anzeigevorrichtung nach Anspruch 1, wobei die Lichtquellen (213) in einem Raster angeordnet sind.

4. Transparente Anzeigevorrichtung nach Anspruch 1, wobei die fotoaktive Schicht (233) umfasst:
Farbstoffmoleküle, die dazu eingerichtet sind, bei Empfang von Sonnenenergie Elektronen zu erzeugen;
nanoporöse Titanoxidpartikel, die die Farbstoffmoleküle adsorbiert haben; und einen Elektrolyten.

## Revendications

1. Ensemble comprenant une fenêtre (10) doté d'un cadre (20) et un dispositif d'affichage transparent monté sur la fenêtre (10),
le dispositif d'affichage transparent comprenant:
une première base (211) et une deuxième base (231) constituées chacune d'un matériau transmissif à la lumière;
une pluralité de sources lumineuses (213) disposées entre la première base (211) et la deuxième base (231);
une carte de circuit imprimé d'écran (215) conçu pour commander les sources lumineuses (213) et disposé à une extrémité de la première base (211);
une électrode transparente (214) connectant les sources lumineuses et la carte de circuit imprimé d'écran (215);
une couche photoactive (233) formée sur la deuxième base (231) afin de convertir la lumière solaire en énergie électrique;
une batterie (235) conçue pour stocker l'énergie électrique générée par la couche photoactive et disposée à l'extrémité de la première base (211) avec la carte de circuit imprimé d'écran (215);
une troisième base (232) disposée de manière à recouvrir la couche photoactive; et
une couche adhésive transparente (220) stratifiée sur la troisième base (232) et collée à la fenêtre,
dans lequel la carte de circuit imprimé d'écran (215) est alimentée par la batterie (235), et
dans lequel la batterie (235) et la carte de circuit imprimé d'écran (215) sont disposées sur le cadre (20) de la fenêtre avec la carte de circuit imprimé d'écran (215).

2. Dispositif d'affichage transparent selon la revendication 1, comprenant en outre:
un contrôleur système conçu pour fournir un signal d'image à la carte de circuit imprimé d'écran (215),
dans lequel le contrôleur système est commandé par l'énergie fournie par la batterie (235).

3. Dispositif d'affichage transparent selon la revendication 1, dans lequel les sources lumineuses (213) sont disposées dans une grille.

4. Dispositif d'affichage transparent (10) selon la revendication 1, dans lequel la couche photoactive (233) comprend:
des molécules de colorant conçues pour générer des électrons lorsqu'elles reçoivent de l'énergie solaire;
des particules nanoporeuses d'oxyde de titane ayant absorbé les molécules de colorant; et
un électrolyte.
